(19) Europäisches Patentamt
European Patent Office
Office européen des brevets

(11) Publication number : **0 628 877 B1**

(12) **EUROPEAN PATENT SPECIFICATION**

(45) Date of publication of patent specification : **08.03.95 Bulletin 95/10**

(51) Int. Cl.$^6$ : **G03F 7/07**

(21) Application number : **93201648.8**

(22) Date of filing : **09.06.93**

(54) **Method for obtaining a printing plate according to the silver salt diffusion transfer process.**

(43) Date of publication of application : **14.12.94 Bulletin 94/50**

(45) Publication of the grant of the patent : **08.03.95 Bulletin 95/10**

(84) Designated Contracting States : **BE DE FR GB NL**

(56) References cited :
**EP-A- 0 410 500**
**EP-A- 0 482 479**
**EP-A- 0 535 678**
**US-A- 4 003 910**

(73) Proprietor : **AGFA-GEVAERT naamloze vennootschap**
**Septestraat 27**
**B-2640 Mortsel (BE)**

(72) Inventor : **Deprez, Lode, c/o Agfa-Gevaert N.V., DIE 3800**
**Septestraat 27**
**B-2640 Mortsel (BE)**
Inventor : **Vaes, Jos, c/o Agfa-Gevaert N.V., DIE 3800**
**Septestraat 27**
**B-2640 Mortsel (BE)**
Inventor : **Gestels, Paul, c/o Agfa-Gevaert N.V., DIE 3800**
**Septestraat 27**
**B-2640 Mortsel (BE)**

**EP 0 628 877 B1**

Note : Within nine months from the publication of the mention of the grant of the European patent, any person may give notice to the European Patent Office of opposition to the European patent granted. Notice of opposition shall be filed in a written reasoned statement. It shall not be deemed to have been filed until the opposition fee has been paid (Art. 99(1) European patent convention).

## Description

The present invention relates to a method for making a lithographic printing plate according to the silver salt diffusion transfer process.

Background of the invention.

The principles of the silver complex diffusion transfer reversal process, hereinafter called DTR-process, have been described e.g. in US-P 2,352,014 and in the book "Photographic Silver Halide Diffusion Processes" by André Rott and Edith Weyde - The Focal Press - London and New York, (1972).

In the DTR-process non-developed silver halide of an information-wise exposed photographic silver halide emulsion layer material is transformed with a so-called silver halide solvent into soluble silver complex compounds which are allowed to diffuse into an image-receiving element and are reduced therein with a developing agent, generally in the presence of physical development nuclei, to form a silver image having reversed image density values ("DTR-image") with respect to the black silver image obtained in the exposed areas of the photographic material.

A DTR-image bearing material can be used as a planographic printing plate wherein the DTR-silver image areas form the water-repellant ink-receptive areas on a water-receptive ink-repellant background. A particular interesting type of photographic material for making a printing plate according to the DTR-process comprises in the order given on a support a silver halide emulsion layer and a physical development nuclei containing layer as a surface layer. Such type of photographic material is commercially available under the tradename of SUPERMASTER from Agfa-Gevaert NV and from Mitsubishi Paper Mills under the tradename SILVERMASTER.

These commercial printing plates are generally processed by means of camera plate makers that include an exposure unit as well as a developing unit. Development of the photographic material in most camera plate makers takes place by soaking the photographic material in a developer tank holding developing liquid and subsequent soaking the photographic material in a fixing tank holding a neutralizing liquid. These tanks are large volume tanks typically holding about 5 liters of processing liquid.

An important disadvantage of such large tanks is that the processing liquids deteriorate due to oxidation and processing of photographic material. Consequently there is a need for frequent replacement of the processing liquid which is inconvenient and time consuming.

EP-A-482479 discloses a developing unit wherein the volume of the tanks is reduced to about 0.5 liters. The possibility of uneven development of the photographic material in the developing unit according to EP-A-482479 has been overcome by applying fresh developing liquid from a roller that is continuously wetted with fresh developing liquid and that is partially soaked in the developing liquid.

In a developing unit as disclosed in EP-A-482479 the time that lapses between entrance of the photographic material into the developing liquid and exit of the photographic material out of the developing liquid is substantially reduced with respect to the commonly used developing units. Typically the time that the photographic material resides in the developing liquid in a developing unit as disclosed in EP-A-482479 is generally less than 15s and may even be less than 10s whereas in a commonly developing unit it is about 25s or more.

It has now been found by us that the automatic processing of a photographic material, in particular the commercial materials referred to above, according to the DTR-process in a camera plate maker including a developing station as disclosed in EP-A-482479 results in printing plates of inferior quality. In particular, printing of the obtained plates cannot be garanteed for all types of the most commonly employed inks. Furthermore, the printing quality may still decrease with the number of plates processed, especially when the dipping time in the developing liquid decreases.

These problems may partially be solved by wiping the plates with a hydrophobizing liquid after processing before mounting them on an offset press. However this is cumbersome and inconvenient.

Summary of the invention.

It is an object of the present invention to provide a method for making a printing plate according to the silver salt diffusion transfer process in an automated way using a camera plate maker and which plate does not have the above mentioned disadvantages.

It is a further object of the present invention to provide a method for making a printing plate according to the silver salt diffusion transfer process with reduced dipping times into the developing liquid.

Further objects of the present invention will become clear from the description hereinafter.

According to the present invention there is provided a method for making a lithographic printing plate according to the silver salt diffusion transfer process using a photographic material comprising on a support in the order given a silver halide emulsion layer and a layer containing physical development nuclei comprising the steps of:

- image-wise exposing said photographic material and
- developing a thus obtained image-wise exposed photographic material by guiding said image-wise exposed photographic material through an alkaline processing liquid held in a developer tank; said developer tank comprising a spreading means for providing fresh alkaline processing liquid at the side from which said image-wise exposed photographic material is feeded;

characterized in that said alkaline processing liquid comprises an alkanolamine and a meso-ionic compound.

According to the present invention there is provided a method for making a lithographic printing plate according to the silver salt diffusion transfer process using a photographic material comprising on a support in the order given a silver halide emulsion layer and a layer containing physical development nuclei comprising the steps of:

- image-wise exposing said photographic material and
- developing a thus obtained image-wise exposed photographic material by guiding said image-wise exposed photographic material through an alkaline processing liquid held in a developer tank in 15s or less;

characterized in that said alkaline processing liquid comprises an alkanolamine and a meso-ionic compound.

Detailed description.

According to the present invention it has been found that the problems of printing quality of a printing plate, even when no hydrophobizing solution is used, obtained according to the DTR-process using a small sized developer tank and/or short dipping times can be overcome by adapting the alkaline processing liquid used for developing the printing plate. Thus in accordance with the present invention the alkaline processing liquid comprises an alkanolamine in combination with a meso-ionic compound.

Meso-ionic compounds are well known in silver halide photography and are used e.g. for increasing temperature latitude as disclosed in JP-A-60-117240, for reducing fog as disclosed in US-P-4.615.970, in preparing silver halide emulsions as disclosed in US-P-4.631.253, in bleach etching baths as disclosed in EP-A-321839, to prevent pressure marks as disclosed in US-P-4.624.913 etc.. EP-A-535678 discloses the use of meso-ionic compounds as a silver halide solvent for use in a silver salt diffusion transfer process. Although EP-A-535678 discloses the possibility to use a meso-ionic compound in combination with other silver halide solvents, the disclosure is mainly concerned with the use of a meso-ionic compound as the sole silver halide solvent and does not mention a possibly use of a meso-ionic compound in combination with an alkanolamine. Furthermore in EP-A-535678 it was not realized that the problems encountered with camera plate makers as disclosed in EP-A-482479 could be solved.

Meso-ionic compounds as referred to in the present invention are a group of compounds defined by W. Baker and W.D. Ollis as "5- or 6-membered heterocyclic compounds which cannot be represented satisfactorily by any one covalent or polar structure and possesses a sextet of π-electrons in association with the atoms comprising the ring. The ring bears a fractional positive charge balanced by a corresponding negative charge located on a covalently attached atom or group of atoms" as described in Quart. Rev., Vol. 11, p. 15 (1957) and Advances in Heterocyclic Chemistry, Vol. 19, P. 4 (1976).

Preferred meso-ionic compounds are those represented by formula (I):

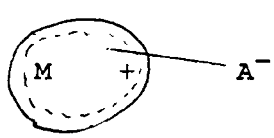

(I)

wherein M represents a 5- or 6-membered heterocyclic ring composed of at least one member selected from the group consisting of a carbon atom, a nitrogen atom, an oxygen atom, a sulfur atom and a selenium atom; and $A^-$ represents $-O^-$, $-S^-$ or $-N^--R$, wherein R represents an alkyl group (preferably having 1 to 6 carbon atoms), a cycloalkyl group (preferably having 3 to 6 carbon atoms), an alkenyl group (preferably having 2 to 6 carbon atoms) an alkynyl group (preferably having 2 to 6 carbon atoms), an aralkyl group, an aryl group (preferably having 6 to 12 carbon atoms), or a heterocyclic group (preferably having 1 to 6 carbon atoms).

In formula (I), examples of the 5-membered heterocyclic ring as represented by M include an imidazolium ring, a pyrazolium ring, an oxazolium ring, an isoxazolium ring, a thiazolium ring, an isothiazolium ring, a 1,3-dithiol ring, a 1,3,4- or 1,2,3 oxadiazolium ring, a 1,3,2-oxathiazolium ring, a 1,2,3-triazolium ring, a 1,3,4-triazolium ring, a 1,3,4-, 1,2,3- or 1,2,4-thiadiazolium ring, a 1,2,3,4-oxatriazolium ring, a 1,2,3,4-tetrazolium ring and a 1,2,3,4-thiatriazolium ring.

Preferred meso-ionic compounds for use in accordance with the present invention are triazolium thiolates and more preferably 1,2,4-triazolium-3-thiolates and most preferably those that correspond to the following formula:

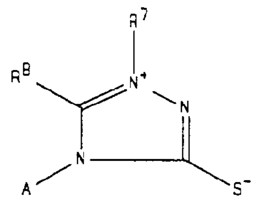

wherein $R^7$ and $R^8$ each independently represents an unsubstituted or substituted alkyl group, alkenyl group, cycloalkyl group, aralkyl group, aryl group or heterocyclic group, A represents an unsubstituted or substituted alkyl group, alkenyl group, cycloalkyl group, aralkyl group, aryl group, heterocyclic group or $-NR^9R^{10}$ wherein $R^9$ and $R^{10}$ each independently represents hydrogen, an alkyl group or aryl group; or $R^7$ and $R^8$ or $R^8$ and A or $R^9$ and $R^{10}$ represent the necessary atoms to form a 5- or 6-membered ring.

Specific examples of 1,2,4-triazolium-3-thiolates suitable for use in accordance with the present invention are shown in table 1.

Table 1

(1)

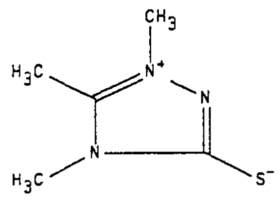

(2)

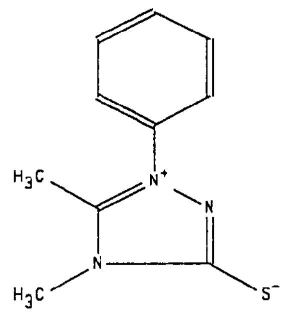

(3)

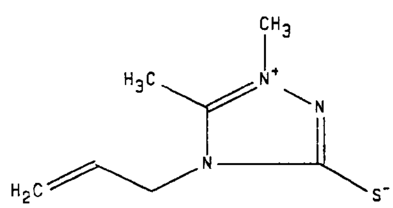

(4)

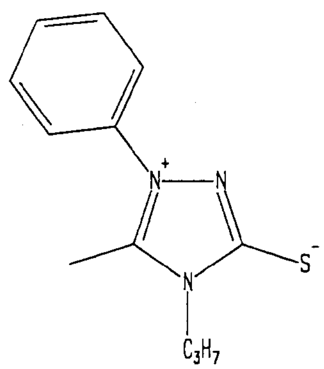

(5)

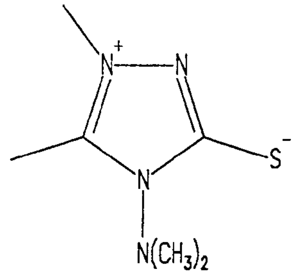

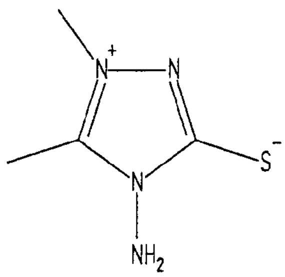

(6)

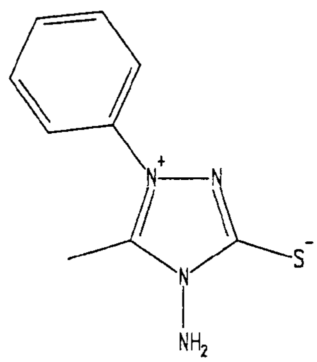

(7)

Preferably the amount of meso-ionic compound in the alkaline processing liquid is between 0.1 mmol/l and 50 mmol/l and more preferably between 0.1 mmol/l and 25 mmol/l and most preferably between 0.5 mmol/l and 10 mmol/l.

Alkanolamines that are suitable for use in accordance with the present invention may be of the tertiary, secundary or primary type. Examples of alkanolamines that may be used in connection with the present invention correspond to the following formula:

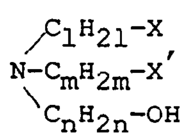

wherein X and X′ independently represent hydrogen, a hydroxyl group or an amino group, l and m represent 0 or integers of 1 or more and n represents an integer of 1 or more. Preferably used alkanolamines are e.g. N-(2-aminoethyl)ethanolamine, diethanolamine, N-methylethanolamine, triethanolamine, N-ethyldiethanolamine, diisopropanolamine, ethanolamine, 4-aminobutanol, N,N-dimethylethanolamine, 3-aminopropanol, N,N-ethyl-2,2'-iminodiethanol or mixtures thereof.

The alkanolamines are preferably used in a concentration of 0.05% to 10% by weight and more preferably in a concentration of 0.05% by weight to 7% by weight.

In addition to the meso-ionic compound and the alkanolamine the alkaline processing liquid can comprise further silver halide solvents. Additional silver halide solvents for use in connection with the present invention are e.g. 2-mercaptobenzoic acid, cyclic imides, oxazolidones, thiocyanates, thioethers and thiosulfates.

Preferably used thioethers correspond to the following general formula:

$$Z\text{-}(R^1\text{-}S)_t\text{-}R^2\text{-}S\text{-}R^3\text{-}Y$$

wherein Z and Y each independently represents hydrogen, an alkyl group, an amino group, an ammonium group, a hydroxyl, a sulfo group, a carboxyl, an aminocarbonyl or an aminosulfonyl, $R^1$, $R^2$ and $R^3$ each independently represents an alkylene that may be substituted and optionally contain a oxygen bridge and t represents an integer from 0 to 10.

Examples of thioether compounds corresponding to the above formula are disclosed in e.g. US-P-4.960.683 and specific examples are listed in table 2

Table 2

| | |
|---|---|
| $(HO-CH_2-CH_2)_2S$ | 1 |
| $HO-CH_2-CH_2-S-CH_2-S-CH_2-CH_2-OH$ | 2 |
| $HO-CH_2-CH_2-S-(CH_2)_2-S-CH_2-CH_2-OH$ | 3 |
| $HO-CH_2-CH_2-S-(CH_2)_3-S-CH_2-CH_2-OH$ | 4 |
| $HO-CH_2-CH_2-S-(CH_2)_4-S-CH_2-CH_2-OH$ | 5 |
| $C_2H_5-S-CH_2-CH_2-S-CH_2-CHOH-CH_2-OH$ | 6 |
| $(HOCH_2-CH_2-S-CH_2-CH_2)_2O$ | 7 |
| $HO-CH_2-CH_2-S-CH_2-CH_2-N(CH_3)_2$ | 8 |
| $(HO-CH_2-CHOH-CH_2-S-CH_2)_2$ | 9 |
| $HOOC-CH_2-S-CH_2-S-CH_2-COOH$ | 10 |
| $HOOC-CH_2-S-(CH_2)_2-S-CH_2-COOH$ | 11 |
| $HOOC-CH_2-S-(CH_2)_3-S-CH_2-COOH$ | 12 |
| $HOOC-(CH_2)_2-S-CH_2-S-(CH_2)_2-COOH$ | 13 |
| $HOOC-(CH_2)_2-S-(CH_2)_2-S-(CH_2)_2-COOH$ | 14 |
| $HOOC-(CH_2)_2-S-(CH_2)_3-S-(CH_2)_2-COOH$ | 15 |
| $CH_3-S-CH_2-CH_2-CH-COOH$<br>$NH_2$ | 16 |

Preferably the silver halide solvent is used in an amount between 0.05% by weight and 10% by weight and more preferably between 0.05% by weight and 7% by weight.

According to the present invention the alkaline processing liquid preferably also contains hydrophobizing agents for improving the hydrophobicity of the silver image obtained in the image receiving layer. The hydrophobizing agents used in connection with the present invention are compounds that are capable of reacting with silver or silver ions and that are hydrophobic i.e. insoluble in water or only slightly soluble in water. Generally these compounds contain a mercapto group or thiolate group and one or more hydrophobic substituents e.g. an alkyl group containing at least 3 carbon atoms. Examples of hydrophobizing agents for use in accordance with the present invention are e.g. those described in US-P 3,776,728, and US-P 4,563,410. Particularly preferred hydrophobizing agents in connection with the present invention are long chain (at least 5 carbon atoms) alkyl substituted mercaptotetrazoles, more in particular those according to the following formula (III):

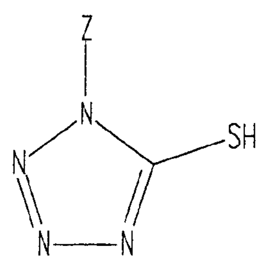

(III)

wherein Z represents a substituted or unsubstituted alkyl, a substituted or unsubstituted aryl, an aralkyl, an alkylaryl, a substituted or unsubstituted alkenyl, a substituted or unsubstituted alkynyl or a heterocyclic ring.

Specific examples of hydrophobizing agents according to formula (III) are listed in table 3.

Table 3

| compound no. | Z in formula (I) |
|---|---|
| 1 | $CH_2CONH\text{-}n.C_6H_{13}$ |
| 2 | $CH_2CON(n.C_4H_9)_2$ |
| 3 | $C_6H_{13}$ |

According to the present invention the hydrophobizing agents may be contained in the alkaline processing liquid in an amount of at least 0.1g/l, more preferably at least 0.2g/l and most preferably at least 0.3g/l. The maximum amount of hydrophobizing agents will be determined by the type of hydrophobizing agent, type and amount of silver halide solvents etc.. Typically the concentration of hydrophobizing agent is preferably not more than 1.5g/l and more preferably not more than 1g/l.

The alkaline processing liquid used in accordance with the present invention preferably has a pH between 9 and 14 and more preferably between 10 and 13. Said pH may be established by an organic or inorganic alkaline substance or a combination thereof. Suitable inorganic alkaline substances are e.g. potassium or sodium hydroxide, carbonate, phosphate etc.. Suitable organic alkaline substances are e.g. alkanolamines. In the latter case the alkanolamines will provide or help maintain the pH and serve as a silver halide complexing agent.

The alkaline processing liquid may also contain the developing agent(s) used in accordance with the present invention. In this case the alkaline processing liquid is called a developer. On the other hand some or all of the developing agent(s) may be present in one or more layers of the photographic material or imaging element. When all of the developing agents are contained in the imaging element the alkaline processing liquid is called an activator or activating liquid.

Silver halide developing agents for use in accordance with the present invention are preferably of the p-dihydroxybenzene type, e.g. hydroquinone, methylhydroquinone or chlorohydroquinone, preferably in combination with an auxiliary developing agent being a 1-phenyl-3-pyrazolidinone-type developing agent and/or p-monomethylaminophenol. Particularly useful auxiliary developing agents are of the phenidone type e.g. 1-phenyl-3-pyrazolidinone, 1-phenyl-4-monomethyl-3-pyrazolidinone, and 1-phenyl-4,4-dimethyl-3-pyrazolidinone. Preferred phenidone type developing agents, particularly when they are incorporated into the photgraphic material are phenidones of which the aqueous solubility is increased by a hydrophilic substituent such as e.g. hydroxy, amino, carboxylic acid group, sulphonic acid group etc. Examples of phenidones subsituted with one or more hydrophilic groups are e.g. 1-phenyl-4,4-dimethyl-2-hydroxy-3-pyrazolidone, 1-(4-carboxyphenyl)-4,4-dimethyl-3-pyrazolidone etc.. However other developing agents can be used.

At least the auxiliary developing agents are preferably incorporated into the photgraphic material. The auxiliary developing agent is preferably incorporated in the photographic material, preferably in the silver halide emulsion layer of the photographic material, in an amount of less than 150mg/g of silver halide expressed as $AgNO_3$, more preferably in an amount of less than 100mg/g of silver halide expressed as $AgNO_3$.

The alkaline processing liquid preferably also contains a preserving agent having antioxidation activity, e.g. sulphite ions provided e.g. by sodium or potassium sulphite. For example, the aqueous alkaline solution comprises sodium sulphite in an amount ranging from 0.15 to 1.0 mol/l. Further may be present a thickening agent, e.g. hydroxyethylcellulose and carboxymethylcellulose, fog inhibiting agents, e.g. potassium bromide, potassium iodide and a benzotriazole which is known to improve the printing endurance, calcium-sequestering compounds, anti-sludge agents, and hardeners including latent hardeners. In accordance with the present invention it is furthermore preferred to use a spreading agent or surfactant in the alkaline processing liquid to assure equal spreading of the alkaline processing liquid over the surface of the photographic material. Such a surfactant should be stable at the pH of the alkaline processing liquid and should assure a fast overall wetting of the surface of the photographic material. A surfactant suitable for such purpose is e.g. a fluor containing surfactant such as e.g. $C_7F_{15}COONH_4$.

Development acceleration can be accomplished with the aid of various compounds to the alkaline processing liquid and/or one or more layers of the photographic element, preferably polyalkylene derivatives having a molecular weight of at least 400 such as those described in e.g. US-P 3,038,805 - 4,038,075 - 4,292,400 - 4, 975,354.

Two embodiments of developing units that can be used in accordance with the present invention will now be described using the following figures 1 to 5 without however the intention to limit the invention thereto.

BRIEF DESCRIPTION OF THE DRAWINGS

Fig. 1 is a perspective view illustrating a developer tank 96.

Fig. 2 is a perspective view illustrating a supply roller 98 and a temporary reservoir 100.

Fig. 3 is a cross sectional view illustrating the arrangement of the supply rolloer 98 and the temporary reservoir 100 with the process tank 96.

Fig. 4 is a perspective view illustrating a developer tank 196.

Fig. 5 is a cross sectional view illustrating the arrangement of the supply roller 98 and the temporary reservoir 100 with the process tank 396.

Referring to figure 1, a preferred developer tank for use in connection with the present invention preferably includes spreading means that comprises a supply roller 98 and a temporary reservoir 100 supplying fresh developer to said supply roller 98.

The U-shaped developer tank 96 shown in figure 1 is a little wider than the photosensitive material . The developer tank 96, as shown in Fig. 1, includes a curved plate and arc-shaped side plates 122 (side plate on the left is omitted in Fig. 1 joined with and fixed to both the ends of the curved plate 120. A through hole 126 is formed near the center of the curved plate 120 on the side of the guide plate 110. Supplying developer from the developer flows out of the through hole 126. Namely, the level of developer is maintained at the height of the through hole 126. Developer flowing out of the through hole 126 and along the guide plate 110 is collected in a waste tray (not shown) below the developer.

The developer tank 96 is provided with a developer supply roller 98 mounted along the width of the tank 96. The developer supply roller 98 is disposed at a certain distance from the bottom of the developer tank 96 and the lower portion thereof is soaked in developer stored in a reservoir.

The surface of the developer supply roller 98 is preferably made of sponge containing lots of seperate pores. As seen in Fig. 2, the developer supply roller 98 is provided with a temporary reservoir 100 for temporarily storing developer dropped downward.

The temporary reservoir 100 shown in Figs. 2 and 3 includes : two side plates 134 in contact with either side of the developer supply roller 98 to allow rotation of the roller 98; and a support plate 136 of a numeral "7" shape connecting the side plates 134 on the side ends of the plate 136. A hole 138, which developer passes through, is formed at a position corresponding to the end of the developer nozzle 82 on the center of an upper plate 136a of the support plate 136. A stainless steel leaf spring 140, which is mounted on a rear plate 136b of the support plate 136, is pressed against the developer supply roller 98 to be in contact with the circumference of the roller 98.

A developer saucer 142 mounted directly below the hole 138 extends from the front center of the upper plate 136a towards the leaf spring 140. There is a small space between the end of the developer saucer 142 and the leaf spring 140. A basin 143 defined by the developer supply roller 98 rotating clockwise, the side plates 134, and the leaf spring 140 pressed against the circumference of the roller 98 can temporarily store developer dripped down from the developer nozzle 82.

The developer saucer 142 efficiently spreads developer along the axis of the developer supply roller 98. Developer is, however, spread along the axis of the developer supply roller 98 even without the developer saucer 142 since the developer is temporarily stored in the basin 143.

Developer dripped down from the developer nozzle 82 passes through the hole 138 to the developer saucer 142, runs from the sides of the developer saucer 142 and through the space between the saucer 142 and the leaf spring 140 as seen in Figs. 2 and 3. Accordingly, the developer is spread along the axis of the developer supply roller 98 and is temporarily stored in the basin 143. Part of the developer stored in the basin 143 is held in the separate pores on the surface of the developer supply roller 98 in a direction shown by the arrow Y of Fig. 3. Since pores are evenly formed along the axis on the surface of the developer supply roller 98, developer is uniformly held on the roller 98.

Since the lower portion of the developer supply roller 98 is soaked in developer stored in the developer tank 96, new developer drawn out with rotation of the developer supply roller 98 is added to the developer stored in the reservoir 95. Newly supplied developer is uniformly diffused in the vicinity of the inlet of the photosensitive material PM in the developer tank 96. While the newly supplied developer increases the level of developer in the reservoir 95, a certain amount of used developer in the reservoir 95, a certain amount of used developer is discharged from the through hole 126 of the curved plate 120. The amount of developer discharged is determined by subtracting a portion lost with conveyance of the photosensitive material PM from the amount of newly supplied developer. Hence the level of developer is maintained constant in the reservoir 95.

A bottom reserve chamber 101 is formed along the width of the developer tank 96 as seen in Figs. 1 and 3. Developer flows in and out through plural apertures 102 formed on the bottom of the developer tank 96. The bottom reserve chamber 101 is provided with two bar heaters 103 for heating the developer. A developer discharge pipe 108 formed below the center of the bottom reserve chamber 101 is connected to the bottom reserve chamber 101 via an electromagnetic valve for opening and closing the discharge pipe 108, and drains used developer into a waste tray.

Developer flown into the bottom reserve chamber 101 is heated with the bar heaters 103 and circulated through the apertures 102 to the reservoir 95. Flow of electricity to the bar heaters is controlled based on feedback data on the temperature of developer detected by a temperature detector, and hence developer in the developer tank 96 is heated in a very short time period and maintained at a predetermined temperature.

When the photosensitive material PM is conveyed through the developer in the reservoir 95 of the developer tank 96, sludge is formed in the developer. The sludge is discharged from the reservoir 95 to the bottom reserve chamber 101, and drained together with the used developer through the discharge pipe 108 into a waste tray while an electromagnetic valve opens.

Conveyance of the photosensitive material PM is described in detail. The exposed photosensitive material PM fed by the pair of feed roller 92 is conveyed along the free roller 94 into the reservoir 95 and passes through the developer along the inner surface of the curved plate 120 of the developer tank 96. The photosensitive material PM reacts with developer stored in the reservoir 95 of the developer supply roller 98 mainly contributes the development of the photosensitive material PM. The photosensitive material PM passing between the developer supply roller 98 and the curved plate 120 in the reservoir 95 is then conveyed along the upper face of the guide plate 110 to the pair of wring roller 109. The temperature of atmosphere above the guide plate 110 is controlled in the vicinity of a predetermined value by heaing with the panel heater 112 with the temperature control function. Development of the photosensitive material PM is proceeded with developer in which the surface of the material PM is drenched while the photosensitive material PM is conveyed along the guide plate 110. Developer in which the surface of the photosensitive material PM is drenched, is wrung out and removed by the pair of wring rollers 109. Development of the photosensitive material PM is accordingly completed.

Another embodiment of a developer tank that may be used in connection with the present invention will be described using figures 4 and 5. Figs. 4 and 5 are a perspective view and a cross sectional view illustrating a developer tank 396, respectively. Similar elements to those of the previous embodiment have the same numerals and symbols.

Photosensitive material PM is conveyed through a pair of feed rollers 92 into the developer tank 396, which is a plate-like tank with an inclined bottom, has a width corresponding to that of the photosensitive material, and includes a reservoir 395 for storing developer as seen in Fig. 4. A partition 97 is supported by legs 97a and mounted parallel to the bottom of the reservoir 395 in the developer tank 396 as shown in Figs. 4 and 5. The partition 97 devides the reservoir 395 between an upper reserve chamber 395a and a lower reserve chamber 395b, which are connected to each other via plural apertures 97b formed in the partition 97. The front end of the partition 97 forms a guide side wall 97c, which is bent upward to the feed roller pair 92 and disposed opposite to a free roller 94.

A developer supply roller 98 extending to the width of the developer tank 396 is disposed at a short distance from the partition 97. When developer is stored in the reservoir 395 of the developer tank 396, the partition 97 is submerged in the developer and the lower portion of the developer supply roller 98 is soaked in the developer in the upper reserve chamber 395a.

Structure of the developer supply roller 98 and of the periphery is the same as that of the previous embodiment.

An auxiliary roller 130 extending to the width of the developer tank 396 is disposed on the opposite side of the developer tank 396 at a short distance from the partition 97. The auxiliary roller 130 rotates synchronously with and in the same direction as the developer supply roller 98 to convey the photosensitive material PM. When developer is stored in the reservoir 395 of the developer tank 396, part of the lower portion of the auxiliary roller 130 is also soaked in the developer in the upper reserver chamber 395a. A trapezoid wave dissipation plate 132 extending to the width of the developer tank 396 is disposed between the developer supply roller 98 and the auxiliary roller 130. The wave dissipation plate 132 is mounted at a short distance from the partition 97 and is partly soaked in developer in the upper reserve chamber 395a.

A bottom reserve chamber 101 is formed below the developer tank 396 and connected thereto through plural apertures formed on the bottom of the developer tank 396. Four heater bars 103 for heating developer are disposed inside the lower reserve chamber 395b separated by the partition 97. A discharge pipe 108 formed below the center of the bottom reserve chamber 101 is connected to the bottom reserve chamber 101 via an electromagnetic valve (not shown) for opening and closing the discharge pipe 108, and drains used developer into a waste tray.

An inclined guide plate 110 is disposed on the outlet of the photosensitive material PM in the developer tank 396, and feeds the developed photosensitive material PM to a pair of wring rollers 109. The guide plate 110 is corrugated so as to decrease the contact resistance to the photosensitive material PM (see fig. 4).

The developer tank 396 includes : a bottom plate 121, an inlet end plate 123, and an outlet end plate 124, which are integrally formed of a stainless steel plate; and side plates 122 (the left side plate is omitted in Fig. 4), which are joined and fixed to the plates 121, 123 and 124, respectively. The bottom plate 121 slopes from

the bent of the inlet end plate 123 to the bent of the outlet end plate 124. The plural apertures 102 formed on the bent between the bottom plate 121 and the outlet end plate 124. A notch window 125 is formed near the center of the outlet end plate 124.

In the developer tank 396, the outlet end plate 124 is inclined at an angle of elevation. The bent between the bottom plate 121 and the outlet end plate 124 and thereby the apertures 102 are positioned on the lowermost part of the developer tank 396.

Since the lower portion of the developer supply roller 98 is soaked in developer stored in the developer tank 396, new developer supply roller 98 is added to the developer stored in the reservoir 395. New developer is uniformly diffused in the vicinity of the inlet of the photosensitive material PM in the developer tank 396. While the newly supplied developer increases the level of developer in the reservoir 395, a certain volume of used developer is discharged from the notch window 125 of the outlet end plate 124. The volume of developer discharged is determined by subtracting a portion lost by conveyance of the photosensitive material PM from the volume of newly supplied developer. Hence the level of developer is maintained constant in the developer tank 396. The notch window 125 and the guide plate 110 are so disposed that developer does not trip on the guide plate 110.

Developer stored in the lower reserve chamber 395b is heated by the four heater bars 103 disposed therein. The warmed developer is circulated from the lower reserve chambers 395b to the upper reserve chamber 395a through the apertures 97b of the partition 97. Supply of electricity to the heater bars 103 is controlled based on feedback data on the temperature of developer. Accordingly, developer in the developer tank 396 is heated within a short time interval and maintained in a predetermined temperature range.

Sludge flowing into the bottom reserve chamber 101 through the apertures 102 of the bottom plate 121 in the developer tank 396 is discharged, together with used developer kept in the bottom reserve chamber 101, into a waste tray via the discharge pipe 108 when an electromagnetic valve is opened.

Conveyance of the photosensitive material PM is as follows. The exposed photosensitive material PM fed by the pair of feed rollers 92 is conveyed along the free roller 94 into the reservoir 395, and passes through developer in the upper reserve chamber 395a along the inner face of the partition 97. Development of the photosensitive material PM is completed while the material PM passes through the upper reserve chamber 395a. Reaction with developer or development starts when the photosensitive material PM travels between the partition 97 and the wave dissipation plate 132, then between the partition 97 and the auxiliary roller 130, and is concluded when the photosensitive material is then conveyed along the inner face of the inclined outlet end plate 124 and the guide plate 110 to the pair of wring rollers 109 of the fixation unit. Excess of developer in which the surface of the photosensitive material PM is drenched, is efficiently wrung out and removed by the pair of wring rollers 109 disposed.

Above there have been described two possible embodiments of a developer tank for use in the method according to the present invention. Subsequent to development in a developer tank in accordance with the present invention the obtained printing plate is preferably guided through a neutralization liquid held in a fixing tank so as to neutralize the alkaline surface of the plate. This tank is preferably similar to the developer tank in connection with the present invention.

A neutralization liquid generally has a pH between 5 and 7. The neutralization liquid preferably contains a buffer e.g. a phosphate buffer, a citrate buffer or mixture thereof. The neutralization solution can further contain bactericides, e.g. phenol, thymol or 5-bromo-5-nitro-1,3-dioxan as described in EP 0,150,517. The liquid can also contain substances which influence the hydrophobic / hydrophilic balance of the printing plate obtained after processing of the DTR element, e.g. silica. Further the neutralization solution can contain wetting agents, preferably compounds containing perfluorinated alkyl groups.

The image-wise exposure in connection with the present invention is preferably accomplished in a camera-plate that also includes a developing station in connection with present invention and preferably also a fixing station. Further details about a particular suitable camera-plate maker in connection with the present invention may be found in EP-A-482479.

The photographic material for use in connection with the method of the present invention comprises on a support in the order given a silver halide emulsion layer and a layer containing physical development nuclei.

Supports suitable for use in accordance with the present invention may be opaque or transparent, e.g. a paper support or resin support. When a paper support is used preference is given to one coated at one or both sides with an Alpha-olefin polymer, e.g. a polyethylene layer which optionally contains an anti-halation dye or pigment. It is also possible to use an organic resin support e.g. cellulose nitrate film, cellulose acetate film, poly(vinyl acetal) film, polystyrene film, poly(ethylene terephthalate) film, polycarbonate film, polyvinylchloride film or poly-Alpha-olefin films such as polyethylene or polypropylene film. The thickness of such organic resin film is preferably comprised between 0.07 and 0.35 mm. These organic resin supports are preferably coated with a hydrophilic adhesion layer which can contain water insoluble particles such as silica or titanium dioxide.

Metal supports e.g. aluminium may also be used in accordance with the present invention.

The image receiving layer containing physical development nuclei is preferably free of hydrophilic binder but may comprise small amounts upto 30% by weight of the total weight of said layer of a hydrophilic colloid e.g. polyvinyl alcohol to improve the hydrophilicity of the surface. Preferred development nuclei for use in accordance with the present invention are sulphides of heavy metals e.g. sulphides of antimony, bismuth, cadmium, cobalt, lead, nickel, palladium, platinum, silver, and zinc. Especially suitable development nuclei in connection with the present invention are palladium sulphide nuclei. Other suitable development nuclei are salts such as e.g. selenides, polyselenides, polysulphides, mercaptans, and tin (II) halides. Heavy metals, preferably silver, gold, platinum, palladium, and mercury can be used in colloidal form.

The photographic silver halide emulsion(s) used in accordance with the present invention can be prepared from soluble silver salts and soluble halides according to different methods as described e.g. by P. Glafkides in "Chimie et Physique Photographique", Paul Montel, Paris (1967), by G.F. Duffin in "Photographic Emulsion Chemistry", The Focal Press, London (1966), and by V.L. Zelikman et al in "Making and Coating Photographic Emulsion", The Focal Press, London (1966).

According to the present invention the emulsion or emulsions preferably consist principally of silver chloride while a fraction of silver bromide may be present ranging from 1 mole % to 40 mole %. Most preferably the amount of bromide is kept below 5 mole %. The emulsions may further contain silver iodide in an amount of upto 5 mole % preferably upto 2 mole %.

In addition to the above described emulsion layer and image receiving layer other hydrophilic colloid layers in water permeable relationship with these layers may be present. For example it is especially advantageous to include a base-layer between the support and the photosensitive silver halide emulsion layer. In a preferred embodiment of the present invention said base-layer serves as an antihalation layer. This layer can therefore contain the same light-absorbing dyes as described above for the emulsion layer ; as alternative finely divided carbon black can be used for the same antihalation purposes as described in US-P 2,327,828. On the other hand, in order to gain sensitivety, light reflecting pigments, e.g. titaniumdioxide can be present. Further this layer can contain hardening agents, matting agents, e.g. silica particles, and wetting agents. At least part of these matting agents and/or light reflection pigments may also be present in the silver halide emulsion layer the most part however preferably being present in said base-layer. As a further alternative the light reflecting pigments may be present in a separate layer provided between the antihalation layer and the photosensitive silver halide emulsion layer.

The hydrophilic layers usually contain gelatin as hydrophilic colloid binder. Mixtures of different gelatins with different viscosities can be used to adjust the rheological properties of the layer. Like the emulsion layer the other hydrophilic layers are coated preferably at a pH value below the isoelectric point of the gelatin. But instead of or together with gelatin, use can be made of one or more other natural and/or synthetic hydrophilic colloids, e.g. albumin, casein, zein, polyvinyl alcohol, alginic acids or salts thereof, cellulose derivatives such as carboxymethyl cellulose, modified gelatin, e.g. phthaloyl gelatin etc.

The hydrophilic layers of the photographic element, especially when the binder used is gelatin, can be hardened with appropriate hardening agents such as those of the epoxide type, those of the ethylenimine type, those of the vinylsulfone type e.g. 1,3-vinylsulphonyl-2-propanol, methylenebis (sulfonylethylene), chromium salts e.g. chromium acetate and chromium alum, aldehydes e.g. formaldehyde, glyoxal, and glutaraldehyde, N-methylol compounds e.g. dimethylolurea and methyloldimethylhydantoin, dioxan derivatives e.g. 2,3-dihydroxy-dioxan, active vinyl compounds e.g. 1,3,5-triacryloyl-hexahydro-s-triazine, active halogen compounds e.g. 2,4-dichloro-6-hydroxy-s-triazine, and mucohalogenic acids e.g. mucochloric acid and mucophenoxychloric acid. These hardeners can be used alone or in combination. The binders can also be hardened with fast-reacting hardeners such as carbamoylpyridinium salts of the type, described in US 4,063,952.

Preferably used hardening agents are of the aldehyde type. The hardening agents can be used in wide concentration range but are preferably used in an amount of 4% to 7% of the hydrophilic colloid. Different amounts of hardener can be used in the different layers of the imaging element or the hardening of one layer may be adjusted by the diffusion of a hardener from another layer.

The present invention will now be illustrated by way of the following example without however the intention to limit the invention thereto. All parts are by weight unless otherwise specified.

EXAMPLE

Preparation of the silver halide emulsion coating solution.

A silver chlorobromide emulsion composed of 98.2mole% of chloride and 1.8mole% of bromide was prepared by the double jet precipitation method. The average silver halide grain size was 0.4μm (diameter of a

sphere with equivalent volume) and contained Rhodium ions as internal dopant. The emulsion was orthochromatically sensitized and stabilized by 1-phenyl-5-mercaptotetrazole.

A base layer coating solution was prepared having the following composition:

| | |
|---|---|
| gelatin | 5.5% |
| carbon black | 0.76% |
| silica particles (5µm) | 1.6% |

Preparation of the imaging element:

The emulsion coating solution and base layer coating solution were simultaneously coated by means of the cascade coating technique to a polyethylene terephthalate support provided with a pack of two backing layers such that the base layer coating was coated directly to the side of the support opposite to the side containing said backing layers. The emulsion layer was coated such that the silver halide coverage expressed as $AgNO_3$ was 1.5g/m$^2$ and the gelatin content was 1.5g/m$^2$. The emulsion layer further contained 0.15g/m$^2$ of 1-phenyl-4,4'-dimethyl-3-pyrazolidone and 0.25g/m$^2$ of hydroquinone. The base layer was coated such that the amount of gelatin in the coated layer was 3g/m$^2$.

The layer nearest to the support of the backing layer pack contained 0.3 g/m$^2$ of gelatin and 0.5 g/m$^2$ of the antistatic agent co (tetraallyloxyethane / methacrylate / acrylic acid-K-salt) polymer. The second backing layer contained 4 g/m$^2$ of gelatin, 0.15 g/m$^2$ of a matting agent consisting of transparent spherical polymeric beads of 3 micron average diameter according to EP 0080225, 0.05 g/m$^2$ of hardening agent triacrylformal and 0.021 g/m$^2$ of wetting agent $F_{15}C_7$-$COONH_4$.

The thus obtained element was dried and subjected to a temperature of 40°C for 5 days and then the emulsion layer was overcoated with a layer containing PdS as physical development nuclei, hydroquinone at 0.4g/m$^2$ and formaldehyde at 100mg/m$^2$.

The following processing solutions were prepared :

Transfer developer A

| | |
|---|---|
| sodium hydroxide (g) | 30 |
| sodium sulphite anh. (g) | 33 |
| potassium thiocyanate (g) | 20 |
| 2-mercapto-5-n.heptyl-oxa-3,4-diazole (mg) | 150 |
| water to make | 1 liter |

Transfer developer B

| | |
|---|---|
| sodium hydroxide (g) | 30 |
| sodium sulphite anh. (g) | 35 |
| compound 3 of table 1 (g) | 1.1 |
| 2-aminoethylaminoethanol (ml) | 30 |
| 2-mercapto-5-n.heptyl-oxa-3,4-diazole (mg) | 150 |
| EDTA (g) | 1 |
| water to make | 1 liter |

EDTA= ethylenediaminetetraacetic acid tetrasodium salt

Transfer developer C

Similar to transfer developer A but with the addition of 3.9g/l of compound 1 of table 1 and wherein the amount

of 2-mercapto-5-n.heptyl-oxa-3,4-diazole was increased to 400mg/l.

Transfer developer D

Similar to transfer developer C but with the addition of 30ml/l of 2-aminoethylaminoethanol.

Neutralization solution

| | |
|---|---|
| citric acid | 10 g |
| sodium citrate | 35 g |
| sodium sulphite anh. | 5 g |
| phenol | 50 mg |
| water to make | 1 l |

4 imaging elements prepared as described above were image-wise exposed using a camera and were subsequently developed using a developing unit according the embodiment of figure 1. The developer tank was filled with one of the 4 transfer developers described above and was kept at 31°C. Subsequent thereto the plates were neutralized using the above neutralization liquid. The dipping times of the imaging elements into the transfer developers was 3s or 9s (see below).

Each of the 4 obtained printing plates was then mounted on an offset press (AD Dick 9850) and were used to print. The ink used was AB Dick 3-1020 and the fountain solution used was 5% of G671c commercially available from Agfa-Gevaert NV and 10% of isopropanol.

The printing results of the plates was evaluated on the 25th copy obtained and are shown in the following table:

| Transfer developer | dipping time | quality of 25th print |
|---|---|---|
| A | 3 | very bad |
| B | 3 | very good |
| C | 3 | very bad |
| D | 3 | very good |
| A | 9 | bad |

## Claims

1. A method for making a lithographic printing plate according to the silver salt diffusion transfer process using a photographic material comprising on a support in the order given a silver halide emulsion layer and a layer containing physical development nuclei comprising the steps of:
   - image-wise exposing said photographic material and
   - developing a thus obtained image-wise exposed photographic material by guiding said image-wise exposed photographic material through an alkaline processing liquid held in a developer tank; said developer tank comprising a spreading means for providing fresh alkaline processing liquid at the side from which said image-wise exposed photographic material is feeded;

   characterized in that said alkaline processing liquid comprises an alkanolamine and a meso-ionic compound.

2. A method according to claim 1 wherein said spreading means comprises a supply roller 98 and a temporary reservoir 100 supplying fresh developer to said supply roller 98.

3. A method for making a lithographic printing plate according to the silver salt diffusion transfer process using a photographic material comprising on a support in the order given a silver halide emulsion layer and a layer containing physical development nuclei comprising the steps of:
   - image-wise exposing said photographic material and
   - developing a thus obtained image-wise exposed photographic material by guiding said image-wise exposed photographic material through an alkaline processing liquid held in a developer tank in 15s or less;

characterized in that said alkaline processing liquid comprises an alkanolamine and a meso-ionic compound.

4. A method according to any of the above claims wherein said meso-ionic compound is a triazolium thiolate.

5. A method according to claim 4 wherein said triazolium thiolate corresponds to the following formula:

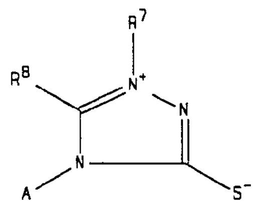

wherein $R^7$ and $R^8$ each independently represents an unsubstituted or substituted alkyl group, alkenyl group, cycloalkyl group, aralkyl group, aryl group or heterocyclic group, A represents an unsubstituted or substituted alkyl group, alkenyl group, cycloalkyl group, aralkyl group, aryl group, heterocyclic group or -$NR^9R^{10}$ wherein $R^9$ and $R^{10}$ each independently represents hydrogen, an alkyl group or aryl group or $R^7$ and $R^8$ or $R^8$ and A or $R^9$ and $R^{10}$ represent the necessary atoms to form a 5- or 6-membered ring.

6. A method according to claim 3 wherein the image-wise exposed photographic material is guided through said alkaline processing liquid in 10s or less.

**Patentansprüche**

1. Ein Herstellungsverfahren für eine lithografische Druckplatte nach dem Silberkomplexdiffusionsübertragungsverfahren unter Verwendung eines fotografischen Materials, das auf einem Träger der angegebenen Reihe nach eine Silberhalogenidemulsionsschicht und eine physikalische Entwicklungskeime enthaltende Schicht umfaßt, das die folgenden Schritte umfaßt :
   - das bildgemäße Belichten des fotografischen Materials, und
   - das Entwickeln eines so erhaltenen bildgemäß belichteten fotografischen Materials, indem es durch eine in einem Entwicklungstank aufbewahrte alkalische Behandlungsflüssigkeit geführt wird, wobei der Entwicklungstank ein Streichsystem enthält. mit dem an der Einführseite des bildgemäß belichteten fotografischen Materials frische alkalische Behandlungsflüssigkeit zugeführt wird,

   dadurch gekennzeichnet, daß die alkalische Behandlungsflüssigkeit ein Alkanolamin und eine mesoionische Verbindung enthält.

2. Verfahren nach Anspruch 1, dadurch gekennzeichnet, daß das Streichsystem eine Zufuhrwalze 98 und einen zeitweiligen Behälter 100, der der Zufuhrwalze 98 frischen Entwickler zuführt, umfaßt.

3. Ein Herstellungsverfahren für eine lithografische Druckplatte nach dem Silberkomplexdiffusionsübertragungsverfahren unter Verwendung eines fotografischen Materials, das auf einem Träger der angegebenen Reihe nach eine Silberhalogenidemulsionsschicht und eine physikalische Entwicklungskeime enthaltende Schicht umfaßt, das die folgenden Schritte umfaßt :
   - das bildgemäße Belichten des fotografischen Materials, und
   - das Entwicklen eines so erhaltenen bildgemäß belichteten fotografischen Materials, indem es innerhalb 15 s oder minder durch eine in einem Entwicklungstank aufbewahrte alkalische Behandlungsflüssigkeit geführt wird,

   dadurch gekennzeichnet, daß die alkalische Behandlungsflüssigkeit ein Alkanolamin und eine mesoionische Verbindung enthält.

4. Ein Verfahren nach irgendeinem der vorstehenden Ansprüche, dadurch gekennzeichnet, daß die mesoionische Verbindung ein Triazoliumthiolat ist.

5. Ein Verfahren nach Anspruch 4, dadurch gekennzeichnet, daß das Triazoliumthiolat der nachstehenden Formel entspricht :

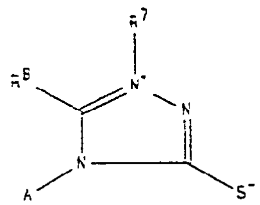

in der bedeuten :

| | |
|---|---|
| $R^7$ und $R^8$ | voneinander unabhängig je eine substituierte oder unsubstituierte Alkyl-, Alkenyl-, Cycloalkyl-, Aralkyl-, Arylgruppe oder heterocyclische Gruppe, |
| A | eine substituierte oder unsubstituierte Alkyl-, Alkenyl-, Cycloalkyl-, Aralkyl-, Arylgruppe, heterocyclische Gruppe oder $-NR^9R^{10}$, in der $R^9$ und $R^{10}$ voneinander unabhängig je Wasserstoff, eine Alkyl- oder Arylgruppe bedeuten, oder $R^7$ und $R^8$ oder $R^8$ und A oder $R^9$ und $R^{10}$ die zur Bildung eines fünf- oder sechsgliedrigen Ringes erforderlichen Atome bedeuten. |

6. Ein Verfahren nach Anspruch 3, dadurch gekennzeichnet, daß das bildgemäß belichtete fotografische Material innerhalb 10 s oder minder durch die alkalische Behandlungsflüssigkeit geführt wird.

## Revendications

1. Un procédé pour la confection d'une plaque d'impression lithographique suivant le procédé de transfert de complexes d'argent par diffusion à l'aide d'un matériau photographique comprenant sur un support dans l'ordre indiqué une couche d'émulsion à l'halogénure d'argent et une couche de germes de développement physique, comportant les opérations suivantes :
   - l'exposition sous forme d'image du matériau photographique, et
   - le développement du matériau photographique exposé sous forme d'image ainsi obtenu, en le faisant passer par un liquide de traitement alcalin conservé dans une cuve de développement comprenant un système d'enduction servant à l'alimentation en liquide de traitement alcalin frais du côté d'entrée du matériau photographique exposé sous forme d'image,

   caractérisé en ce que le liquide de traitement alcalin renferme une alcanolamine et un composé mésoionique.

2. Un procédé suivant la revendication 1, caractérisé en ce que le système d'enduction comprend un rouleau d'alimentation 98 et un réservoir temporaire 100 alimentant le rouleau d'alimentation 98 en révélateur frais.

3. Un procédé pour la confection d'une plaque d'impression lithographique suivant le procédé de transfert de complexes d'argent par diffusion à l'aide d'un matériau photographique comprenant sur un support dans l'ordre indiqué une couche d'émulsion à l'halogénure d'argent et une couche de germes de développement physique, comportant les opérations suivantes :
   - l'exposition sous forme d'image du matériau photographique, et
   - le développement du matériau photographique exposé sous forme d'image ainsi obtenu, en le faisant passer en 15 s ou moins par un liquide de traitement alcalin conservé dans une cuve de développement,

   caractérisé en ce que le liquide de traitement alcalin renferme une alcanolamine et un composé mésoionique.

4. Un procédé suivant l'une quelconque des revendications précédentes, caractérisé en ce que le composé mésoionique est un thiolate de triazolium.

5. Un procédé suivant la revendication 4, caractérisé en ce que le thiolate de triazolium satisfait à la formule suivante :

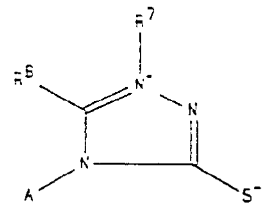

dans laquelle :

$R^7$ et $R^8$ indépendamment l'un de l'autre, représentent chacun un groupe alkyle, alcényle, cycloalkyle, aralkyle, aryle ou un groupe hétérocyclique, substitués ou non,

A représente un groupe alkyle, alcényle, cycloalkyle, aralkyle, aryle, un groupe hétérocyclique, substitués ou non, ou $-NR^9R^{10}$, où $R^9$ et $R^{10}$ indépendamment l'un de l'autre, représentent chacun hydrogène, un groupe alkyle ou aryle, ou $R^7$ et $R^8$ ou $R^8$ et A ou $R^9$ et $R^{10}$ représentent les atomes nécessaires pour former un noyau pentagonal ou hexagonal.

**6.** Un procédé suivant la revendication 3, caractérisé en ce que le matériau photographique exposé sous forme d'image passe par le liquide de traitement alcalin en 10 s ou moins.

Fig. 1

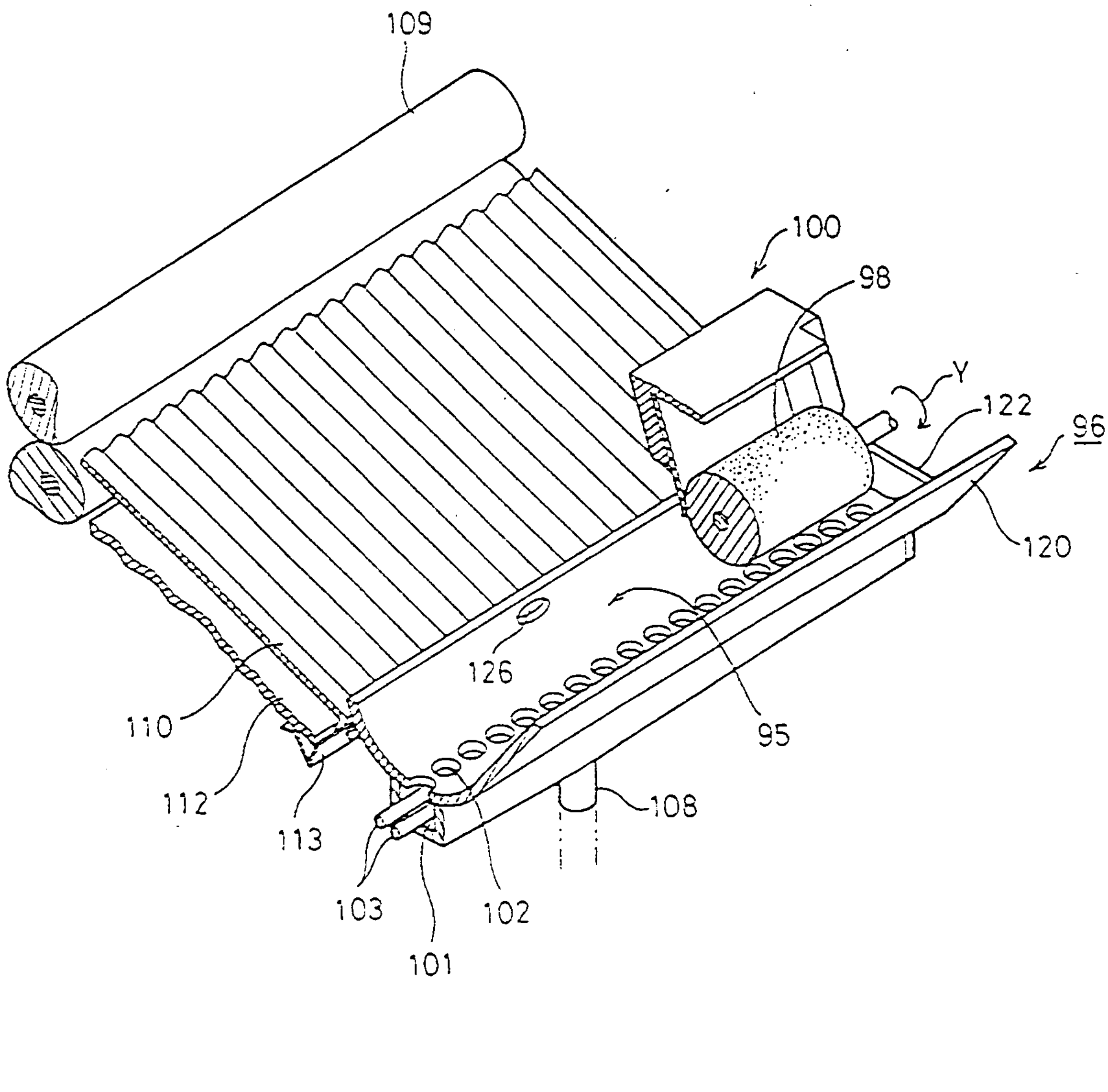

Fig. 2

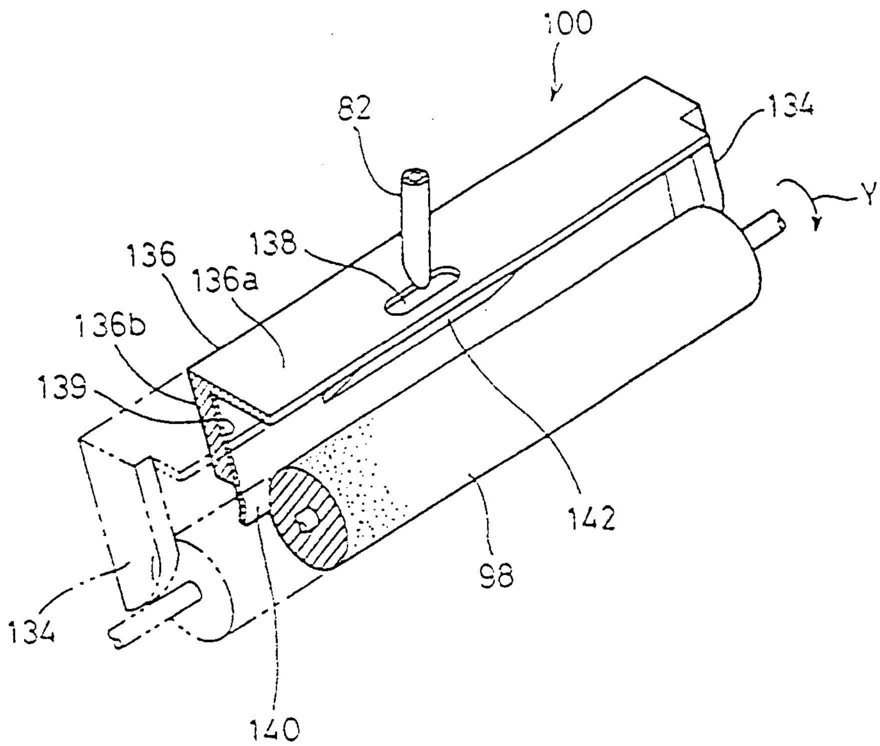
100
82
134
Y
138
136
136a
136b
139
142
98
134
140

Fig. 3

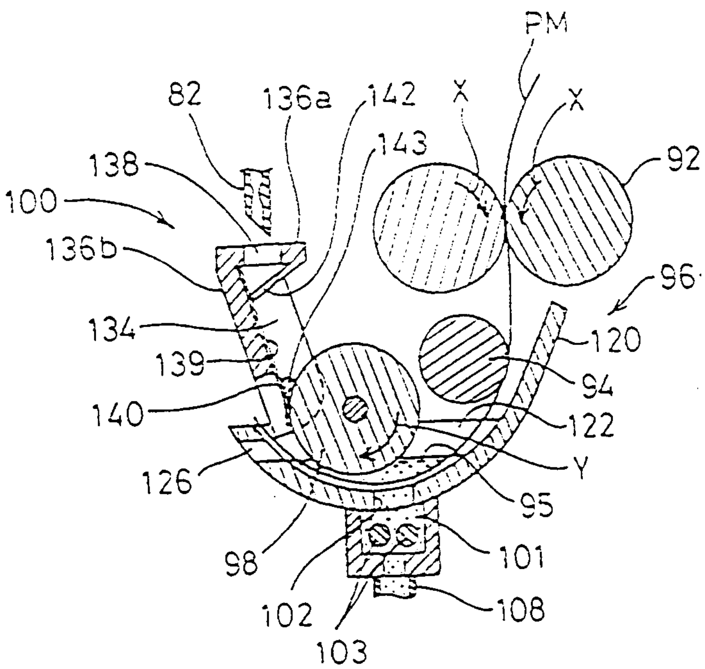
PM
82
136a
142
X
X
143
92
138
100
136b
96
134
120
139
94
140
122
Y
126
95
98
101
102
108
103

Fig. 4

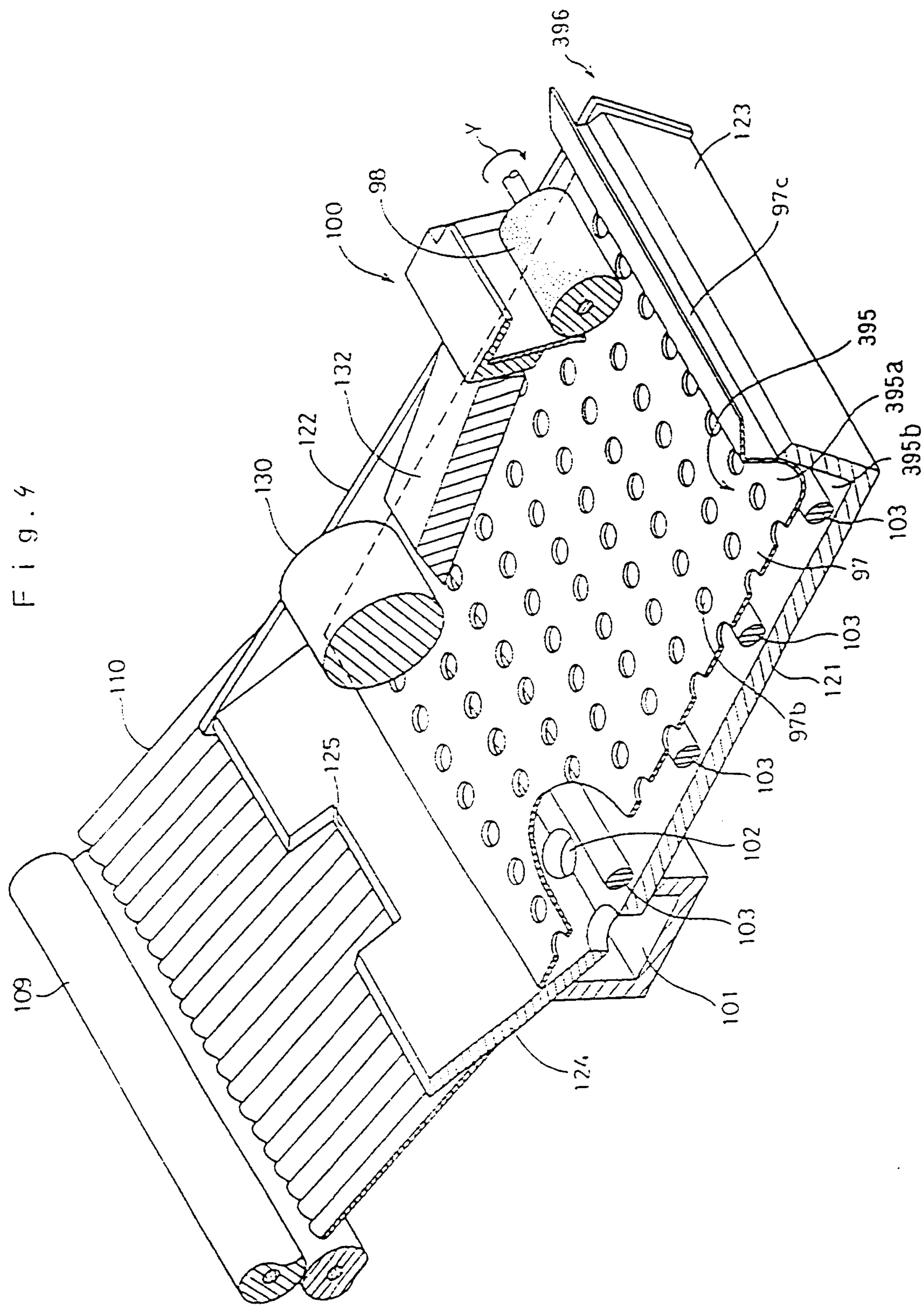
396
123
Y
98
100
97c
395
395a
395b
132
122
130
103
97
103
121
97b
110
125
103
102
103
109
101
124

Fig. 5

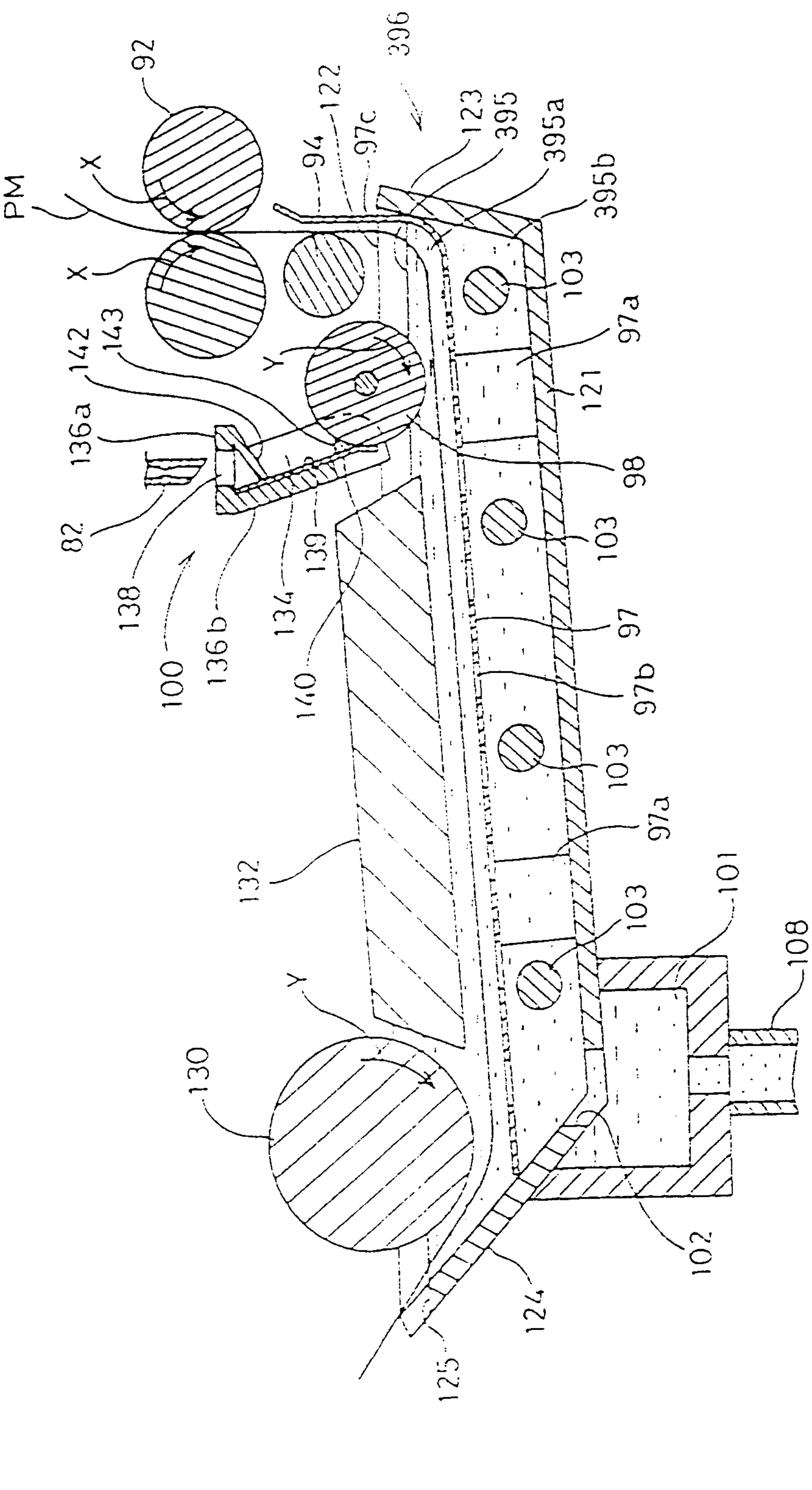
92
X
PM
X
94
122
97c
396
123
395
395a
395b
103
97a
121
Y
142
143
136a
82
98
103
138
136b
134
139
100
140
97
97b
103
97a
132
101
103
108
130
Y
102
124
125